# EUROPÄISCHE PATENTSCHRIFT

(11) **EP 0 891 272 B1**
(45) Veröffentlichungstag und Bekanntmachung des Hinweises auf die Patenterteilung: **09.08.2000**
(21) Anmeldenummer: 98906807.7
(22) Anmeldetag: 15.01.1998
(51) Int. Cl.: B60S 1/08, G01R 31/34, B60S 1/58

(54) **STEUERVORRICHTUNG MIT EINEM WISCHERMOTOR**
CONTROL DEVICE FOR A WINDSHIELD WIPER MOTOR
DISPOSITIF DE COMMANDE DE MOTEUR D'ESSUIE-GLACE

(30) Priorität: 08.02.1997 DE 19704807
(43) Veröffentlichungstag der Anmeldung: 20.01.1999
(73) Patentinhaber: ROBERT BOSCH GMBH, 70442 Stuttgart (DE)
(72) Erfinder: GRASS, Ansgar, D-77652 Offenburg (DE)
(86) Internationale Anmeldenummer: DE9800125
(87) Internationale Veröffentlichungsnummer: WO9834820

(56) Entgegenhaltungen:
- EP-A- 0 252 481
- EP-A- 0 511 495
- EP-A- 0 704 343
- DE-A- 4 402 476
- US-A- 4 617 510
- US-A- 5 568 058

## Beschreibung

### Stand der Technik

Die Erfindung geht aus von einer Steuervorrichtung mit einem Wischermotor nach dem Oberbegriff des Hauptanspruchs. Eine derartige Steuerung ist beispielsweise aus der EP-A-0511495 bekannt.

Zum Abschluß der Fertigung von Wischermotoren müssen diese für die Fertigungsendprüfung dauerhaft bestromt werden. Während der Dauer von ca. 5 bis 6 Sekunden werden dabei die funktionsrelevanten Daten und die Leistungsdaten des Wischermotors geprüft. Die dauerhafte Bestromung des Wischermotors ist mit einer dem Dauerwischen entsprechenden Funktion gleichzusetzen.

Bei einem Heckwischermotor mit einer am Motor angeordneten Steuerung (integrierte Steuerung), dessen Funktionsumfang nur Heckintervallwischen und Heckwaschen beinhaltet, muß daher für die Endprüfung die Funktion Heckwaschen aktiviert werden. Die Funktion Heckwaschen setzt sich aus drei Phasen zusammen: der Motoranlaufverzögerung, während dessen die Scheibe bereits mit Wasser benetzt wird, dem anschließender Wischen bzw. Wischwaschen und dem Trockenwischen (meistens zwei bis drei Nachlaufzyklen). Nachteilig für die Endprüfung sind hierbei die aus der Motoranlaufverzögerung und dem Trockenwischen resultierenden Zeitverluste. Oder anders ausgedrückt, die Taktzeit der Fertigung je Motor erhöht sich dabei in unnötiger Weise um die Zeit der Motoranlaufverzögerung und des über die Prüfzeit hinausgehenden Trockenwischens.

### Vorteile der Erfindung

Die erfindungsgemäße Steuervorrichtung mit den kennzeichnenden Merkmalen des Hauptanspruchs hat den Vorteil, daß der Steuerung ein durch diese erkennbares Testsignal zugeführt wird, das zu einer dauerhaften Bestromung des Motors während der Prüfdauer führt. Nach dem Ausschalten des Testsignals entfällt das Trockenwischen, so daß schnell und quasi verzögerungsfrei die Endprüfung beendet wird.

Einzusetzen ist diese Steuervorrichtung bei Motoren mit integrierter Steuerung, da hierbei Motor und Steuerung bei der Fertigungsendprüfung eine zu prüfende Einheit bilden.

Durch die in den Unteransprüchen aufgeführten Maßnahmen ergeben sich vorteilhafte Weiterbildungen und Verbesserungen der im Hauptanspruch angegebenen Merkmale.

Besonders vorteilhaft ist beispielsweise, wenn die Anwahl der Endprüfung durch Lenkstockschaltersignale ermöglicht wird. D.h., daß durch eine geeignete Kombination von Schaltsignalen am Signaleingang der Steuerung, z.B. ausgelöst durch die Betätigung eines Schaltelements, das einem Lenkstockschalter mit einem oder mehreren Tastern für die Funktionen Intervallwischen und/oder Waschen entspricht, diese als Testsignal von der Steuerung erkannt werden und damit die Endprüfung durchführbar ist.

Alternativ ist vorteilhaft, daß ein am Signaleingang der Steuerung angelegtes negatives Testsignal durch die Steuerung erkannt wird und damit die Endprüfung durchführbar ist. Hierbei führt das Erkennen des Testsignals außerdem zu einer sofortigen dauerhaften Bestromung des Motors und gestattet somit einen schnellen und quasi verzögerungsfreien Start der Endprüfung des Motors. Vorteilhaft ist weiterhin, daß die dauerhafte Bestromung des Motors zu Prüfzwecken durch den Kraftfahrzeugfahrer nicht unabsichtlich ausgelöst werden kann.

Die Dauer des angelegten Testsignals ist variabel und ist im Hinblick auf die erwünschte Dauer der Endprüfung zu wählen.

Ein zusätzlicher Vorteil ergibt sich bei der Integration der Steuerlogik und der Halbleiterendstufe in einem am Motor angeordneten ASIC (Anwendungsspezifischer IC). Die Steuervorrichtung wird auf diese Weise kostengünstig ausgeführt.

### Zeichnung

Ausführungsbeispiele der Erfindung sind in der Zeichnung dargestellt und in der nachfolgenden Beschreibung näher erläutert. Es zeigen
Figur 1 eine am Motor integrierte Steuervorrichtung zum Antrieb eines Heckscheibenwischers,
Figur 2 Signale oder Pegel von Schaltelement, Motor, Test-.modus für Endprüfung und Parklagenschalter,
Figur 3 ein vereinfachtes Schaltbild zur Aktivierung der Endprüfung mittels negativem Testsignal.

### Beschreibung der Ausführungsbeispiele

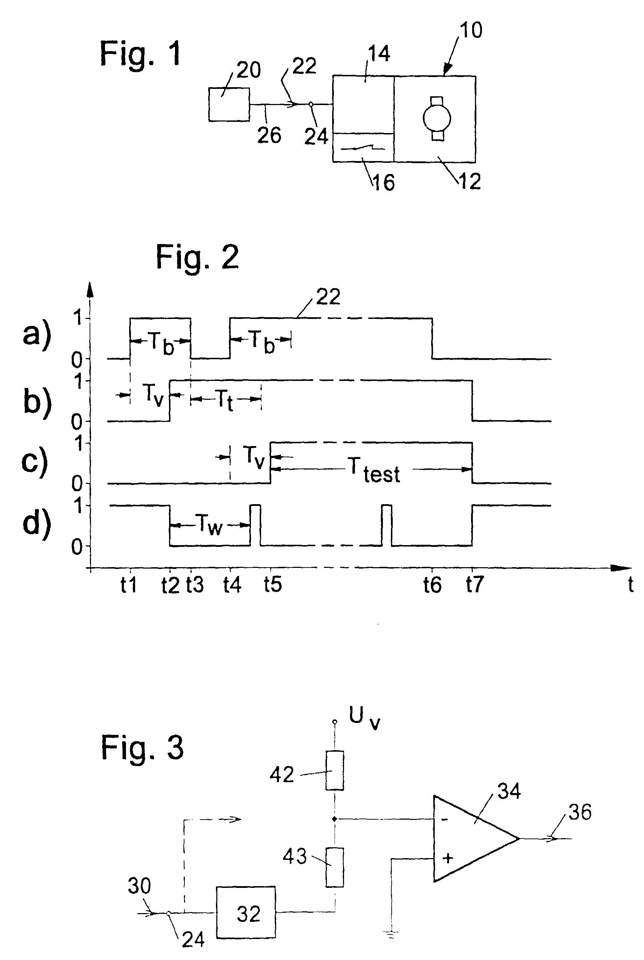

Figur 1 zeigt eine Steuervorrichtung 10 mit einer an einem Heckwischermotor 12 integrierten Steuerung 14 mit Halbleiterendstufe. Ein am Motor 12 bzw. in dessen Getriebe angeordneter Parklagenschalter 16 liefert Parklagensignale an die Steuerung 14. Als Parklagenschalter 16 findet häufig ein Hallsensorsystem oder eine Kontaktscheibe Verwendung. Bei einem Hallsensorsystem ist ein Gebermagnet auf dem Stirnrad des Motors 12 und der Hallsensor auf einer Leiterplatte angeordnet. Bei der auf dem Stirnrad angebrachten Kontaktscheibe ist die Verbindung zur Leiterplatte mit einem Kontaktfinger realisiert.

Der Motor 12 gelangt für die Fertigungsendprüfung in einen nicht dargestellten Prüfstand. Der Motor 12 treibt keinen Wischer an, jedoch wird die Last des Wischers durch eine Mo torbremse simuliert.

Ein Schaltelement 20 im Prüfstand, daß einem Schaltelement mit einem Taster an einem Lenkstockschalter im Kraftfahrzeug entspricht, liefert Schaltsignale 22 über eine Signalleitung 26 als Eingangssignale auf den Signaleingang 24 der Steuerung 14, um den Testmodus der Endprüfung einzuleiten. Der Testmodus führt zu einer dauerhaften Bestromung des Motors 12 über die Zeit, in der die Eingangssignale vorliegen. Für den Testmodus genügt meistens eine Zeit von fünf bis sechs Sekunden.

Figur 2 zeigt Schaltsignale 22 des Schaltelements 20 sowie Pegelverläufe für den Motor 12, Testmodus und Parklagenschalter 16. Der Signalverlauf a) gibt die Schaltsignale 22 des Schaltelements 20 wieder, wobei der Grundzustand des Schaltsignals 22 inaktiv (0) ist; Verlauf b) zeigt das Ein- und Ausschalten beim Bestromen des Motors 12; Verlauf c) bezieht sich auf die Steuerung für den Betrieb des Motors (12) im Testmodus; Verlauf d) entspricht dem Parklagensignal des Parklagenschalters 16, dessen Grundzustand bei ausgeschaltetem Motor, d.h. der Wischer befindet sich in seiner Parklage, aktiv (1) ist.

Die erfindungsgemäße Steuervorrichtung 10 nach Figur 1 arbeitet nach Figur 2 folgendermaßen.

Bei einer zeitcodierten Steuerung 14 werden die beiden Funktionen Heckintervallwischen und Heckwaschen durch unterschiedlich lange Schaltsignale 22, die auf einer einzigen Signalleitung 26 der Steuerung 14 zugeführt werden, ausgelöst. Das Schaltsignal 22 wird durch die Betätigung des Tasters am Schaltelement 20 aktiviert (Übergang 0 nach 1). Ein Zeitraster in der Steuerung 14 ist dabei derart eingestellt, daß bei Betätigung des Tasters für eine Betätigungsdauer Tb größer als eine Verzögerungszeit Tv (Tb > Tv) die Funktion Heckwaschen ausgeführt wird. Die Verzögerungszeit Tv entspricht dabei der Motoranlaufverzögerung bei der Funktion Heckwaschen und liegt oft in einer Größenordnung von einer Sekunde. Während der Verzögerungszeit Tv wird die Scheibe bereits mit Wasser bespritzt. Nach der Verzögerungszeit Tv wird der Motor 12 bestromt und die Phase Wischwaschen beginnt. Mit Loslassen des Tasters bzw. Deaktivieren des Schaltsignals 22 hört die Benetzung mit Wasser auf und die Phase Wischwaschen geht in die Phase Trockenwischen Tt über. Die Zahl der Trockenwischzyklen ist in der Steuerung 14 meistens auf zwei oder drei festgelegt.

Ist die Betätigungsdauer kleiner als die Verzögerungszeit (Tb < Tv, Antippen des Tasters), so wird die Funktion Heckintervallwischen gestartet. Dabei muß eine kurze Benetzung der Scheibe mit Wasser hingenommen werden. Mit Loslassen des Tasters startet der Motor 12 sofort mit dem Intervallwischen. Durch ein nochmaliges Antippen des Tasters wird das Intervallwischen beendet.

Die Betätigungsdauer Tb muß jedoch immer größer als eine Mindestdauer sein, die durch die Entprellzeit der Schaltung von z.B. 50 Millisekunden vorgegeben ist.

Für die Fertigungsendprüfung wird der Motor 12 in einen Prüfstand eingelegt und die Steuerung 14 mit mindestens drei Zuleitungen versehen: eine Signalleitung 26 und zwei nicht dargestellte Zuleitungen für die Spannungsversorgung des Motors 12. Bei der Endprüfung des Heckwischermotors soll nun der Testmodus Tₜₑₛₜ angewählt werden. Dazu wird als erstes die Funktion Heckwaschen zum Zeitpunkt tl nach Figur 2 über die Signalleitung 26 durch das Prüfprogramm des Prüfstandes aktiviert, d.h., daß das Schaltsignal 22 des Schaltelements 20 länger als die Verzögerungszeit Tv vorliegen muß. Da der Motor 12 im Prüfstand nicht an eine Waschwasserpumpe angeschlossen ist, wird dabei kein Wasser befördert.

Nach Ablauf der Verzögerungszeit Tv zum Zeitpunkt t2 = t1 + Tv, wird der Motor 12 durch die Steuerung 14 eingeschaltet (Signalverlauf b) und damit die Phase Wischwaschen gestartet. Zum Zeitpunkt t3 wird das Schaltsignal 22 deaktiviert Damit geht die Phase Wischwaschen in die Phase Trockenwischen Tt über. Synchron zur Drehung des Stirnrads am Motor 12 gibt der Parklagenschalter 16 das Parklagensignal ab: inaktiv (0) außerhalb der Parklage und aktiv (1) in der Parklage (Signalverlauf d).

Während des Trockenwischens Tt muß die Funktion für das Heckwaschen (Signalverlauf a) ein zweites Mal aktiviert werden. Dies geschieht durch Aktivierung des Schaltsignals 22 noch innerhalb des ersten Wischzyklusses Tw zum Zeitpunkt t4 für die Betätigungsdauer größer als die Verzögerungszeit (Tb > Tv). Diese Kombination von Schaltsignalen 22 wird von der Steuerung 14 als Testsignal erkannt und führt zu der Aktivierung des Testmodus Tₜₑₛₜ zum Zeitpunkt t5 = t4 + Tv (Signalverlauf c). Ebenfalls zu dem im Prüfprogramm abgelegten Zeitpunkt t5 wird die Endprüfung des Motors 12 gestartet. Das Prüfprogramm sieht dabei u.a. Strom- und Drehzahlmessungen des Motors 12 bei unterschiedlichen Versorgungsspannungen des Motors 12 auf dem Prüfstand vor. Während der Endprüfung bleibt das zweite Schaltsignal 22 aktiviert und damit auch der Testmodus Tₜₑₛₜ.

Zum Zeitpunkt t6 wird das Schaltsignal 22 wieder deaktiviert. Der Motor 12 wird durch den Testmodus Tₜₑₛₜ von der Steuerung 14 jedoch erst zum Zeitpunkt t7 ausgeschaltet (zeitgleich mit dem Ausschalten des Testmodus Tₜₑₛₜ), wenn der Parklagenschalter 16 die Parklage detektiert. Nur wenn die Deaktivierung des Schaltsignals 22 mit dem Aktivieren des Parklagensignals zeitlich zusammenfällt (t6 = t7), erfolgt ein weiterer Wischzyklus Tw, um die Stellung des Stirnrads in der Parklage zu gewährleisten.

In einer nicht dargestellten alternativen Anordnung des Ausführungsbeispiels nach Figur 1 werden die Signale für die Funktionen Intervallwischen und Heckwaschen über zwei getrennte Signalleitungen der Steuerung 14 zugeführt. Das Schaltelement 20 entspricht also einem Lenkstockschalter mit zwei Tastern, wobei der Taster für die Funktion Heckwaschen bei kürzerer Betätigungsdauer als die Verzögerungszeit (Tb < Tv) direkt, jedoch nach vorheriger kurzer Benetzung der Scheibe mit Wasser, die Phase Trockenwischen Tt auslöst. Bei längerer Betätigung (Tb > Tv) wird die Funktion Heckwaschen wie oben beschrieben aktiviert. Der Taster für die Funktion Intervallwischen schaltet hier lediglich Intervallwischen ein und aus.

Zum Einschalten des Testmodus durch das Prüfprogramm wird das Schaltsignal 22 auf der Signalleitung 26 für die Funktion Heckwaschen für die Betätigungsdauer kleiner als die Verzögerungszeit (Tb < Tv) aktiviert. Während des hierdurch ausgelösten Trockenwischens Tt muß das Schaltsignal 22 auf derselben Signalleitung 26 ein zweites Mal für die Betätigungsdauer größer als die Verzögerungszeit (Tb > Tv) aktiviert werden.

Hier kann nun der Testmodus schneller gestartet werden, da die erstmalige Betätigungsdauer Tb für die Funktion Heckwaschen kürzer als die vorgegebene Verzögerungszeit Tv erfolgen kann.

Die beschriebene zweimalige Aktivierung der Funktion Heckwaschen bei einer Signalleitung 26 oder der Schaltsignale 22 bei zwei Signalleitungen zum Einschalten des Testmodus ergibt sich durch die Forderung, daß die Wahrscheinlichkeit für ein unbeabsichtigtes Auslösen des Testmodus bei einer in einem Kraftfahrzeug eingebauten Heckwischervorrichtung durch den Kraftfahrzeugfahrer zu minimieren ist.

In einem zweiten Ausführungsbeispiel wird für die Endprüfung eine Schaltung nach Figur 3 in der Steuerung 14 nach Figur 1, vorzugsweise am Signaleingang 24 für die Funktion Heckwaschen, eingebaut.

Das Eingangssignal 30 am Signaleingang 24 der Steuerung 14 wird zuerst durch einen Entprellfilter 32 entprellt und anschließend auf einen invertierenden Eingang (-) eines Komparators 34 gelegt. Die Widerstände 42, 43 dienen zur Strombegrenzung und als Spannungsteiler, wenn ein Potential an den Signaleingang 24 gelegt wird. Wird kein Potential an den Signaleingang 24 angelegt, dann wirken die Widerstände 42, 43 als Pull-up-Widerstände für das Potential am Signaleingang 24 und am invertierenden Komparatoreingang. Das Ausgangssignal 36 des Komparators 34 wird einer Steuerlogik in der Steuerung 14 zugeführt. Je nach Ausgangssignal 36 wird der Testmodus Tₜₑₛₜ eingeschaltet oder nicht eingeschaltet. Diese Schaltung ist vorzugsweise in einem ASIC integriert, das u.a. zusätzlich die Steuerlogik für die Heckwischerfunktionen beinhaltet. Die Auswahl der Heckwischerfunktionen wird über Maskenprogrammierung realisiert. Die Schaltung nach Figur 3 wird mit einer positiven Spannung Uv von ca. 7 V versorgt.

Die erfinderische Steuervorrichtung nach Figur 1 mit der Schaltung nach Figur 3 arbeitet folgendermaßen.

Das Eingangssignal 30 kann sowohl eines der Schaltsignale 22 des Schaltelements 20 aus Figur 1 als auch ein unabhängig von diesen zugeführtes Testsignal sein. Bei einem in einem Kraftfahrzeug eingebauten Wischermotor 12 werden im normalen Betriebszustand durch den Fahrer mittels eines dem Schaltelement 20 entsprechenden Lenkstockschalters lediglich positive Schaltsignale 22 als Eingangssignal 30 der Steuerung 14 zugeführt. Diese Eingangssignale 30 führen zu keiner Aktivierung des Testmodus. Sie werden, wie gestrichelt angedeutet, in einer zu dieser Schaltung parallel angeordneten nicht dargestellten weiteren Schaltung in bekannter Weise in der Steuerung 14 ausgewertet. Bei der in einem Kraftfahrzeug eingebauten Heckwischervorrichtung ist die Endprüfung des Motors 12 somit nicht durchführbar.

Der zur Endprüfung im Prüfstand eingebaute Motor 12 hat anfangs kein Eingangssignal 30 am Signaleingang 24 der Steuerung 14 anliegen. Durch den Pull-up-Widerstand 42 wird daher der invertierende Eingang des Komparators 34 auf ein höheres Potential gelegt als der nicht invertierende auf Masse liegende Eingang (+). Der Pegel des Ausgangssignals 36 des Komparators 34 mit logischem Ausgang beträgt daher Null (aus). Bei einem Eingangspotential von größer bzw. gleich Null steht am invertierenden Eingang des Komparators 34 weiterhin eine positive Spannung an. Das Ausgangssignal 36 ändert daher seinen Pegel nicht.

Zur Aktivierung des Testmodus für die Endprüfung wird als Eingangssignal 30 ein negatives Rechtecksignal als Testsignal angelegt. Das negative Testsignal kann typischerweise eine Spannung von -10 Volt aufweisen. Je nach Dimensionierung der Widerstände 42, 43 liegt in diesem Fall eine negative Spannung am invertierenden Eingang des Komparators 34 an. Beim Nulldurchgang der am invertierenden Eingang anliegenden Spannung springt der Pegel des Ausgangssignals 36 auf Eins (ein). Die Pegeländerung des Ausgangssignals 36 wird von der nachgeschalteten Steuerlogik detektiert, die ihrerseits sofort den Testmodus für den Wischermotor 12 auslöst. Der Testmodus bleibt solange aktiviert, wie das negative Testsignal am Signaleingang 24 der Steuerung 14 anliegt. Der Abschaltvorgang des Testmodus und des Motors 12 wird wie oben beschrieben ausgeführt.

Negative Spannungsspitzen, die z. B. im Bordnetz eines Kraftfahrzeugs auftreten können, werden durch den Entprellfilter 32 ausgelöscht und lösen somit keinen Testmodus aus. Positive Spannungsspitzen führen nicht zu einer Pegeländerung am Signalausgang des Komparators 34. Sie werden jedoch ebenfalls durch den Entprellfilter 32 ausgelöscht.

Die Schaltanordnung nach Figur 3 kann auf jeden Signaleingang der Steuerung 14 gelegt werden. Dies kann ebenfalls ein separater Signaleingang der Steuerung 14 sein, d.h. ein Eingang dem lediglich die Testsignale zugeführt werden.

## Patentansprüche

1. Steuervorrichtung (10) mit einem Wischermotor (12) für Kraftfahrzeuge, insbesondere einem Heckwischermotor (12), und einer am Motor (12) integrierten Steuerung (14) mit wenigstens einem Signaleingang (24), dadurch gekennzeichnet, daß die Steuerung (14) über diesen Signaleingang (24) ein Testsignal erhält und bei dessen Auftreten den Motor (12) für einen Testmodus (Tₜₑₛₜ) bestromt.

2. Steuervorrichtung nach Anspruch 1, dadurch gekennzeichnet, daß der Signaleingang (24) für das Testsignal zugleich der Signaleingang (24) für Schaltsignale (22) eines Schaltelementes (20) zur Anwahl der Funktionen Intervallwischen und/oder Waschen ist, und daß die Steuerung (14) an diesem Signaleingang (24) ein bestimmtes von den Schaltsignalen (22) zum Intervallwischen oder Waschen abweichendes Signal als Testsignal erkennt und bei dessen Auftreten den Motor (12) für einen Testmodus (Tₜₑₛₜ) bestromt.

3. Steuervorrichtung nach Anspruch 2, dadurch gekennzeich net, daß das Testsignal aus einer zeitlichen Abfolge von Schaltsignalen (22) gebildet ist.

4. Steuervorrichtung nach Anspruch 1 oder 2, dadurch gekennzeichnet, daß das Testsignal einen negativen Spannungspegel aufweist.

5. Steuervorrichtung nach einem der vorhergehenden Ansprüche, dadurch gekennzeichnet, daß mit der Dauer des Testsignals die Dauer der Bestromung des Motors (12) festgelegt ist.

6. Steuervorrichtung nach einem der vorhergehenden Ansprüche, dadurch gekennzeichnet, daß nach Ausschalten des Testsignals der Motor (12) für die restliche Dauer des aktuellen Wischzyklusses (Tw) oder für die Dauer eines Wischzyklusses (Tw) bestromt bleibt.

7. Steuervorrichtung nach Anspruch 4, dadurch gekennzeichnet, daß sie einen Entprellfilter (32) und einen Komparator (34) zur Erkennung des Testsignals aufweist, die beide vorzugsweise in einem ASIC (Anwendungsspezifischer IC) integriert sind.

## Claims

1. Control device (10) having a wiper motor (12) for motor vehicles, particularly a rear wiper motor (12), and a controller (14) which is integrated on the motor (12) and has at least one signal input (24), characterized in that the controller (14) receives a test signal via this signal input (24) and, when this test signal occurs, powers the motor (12) for a test mode (Tₜₑₛₜ).

2. Control device according to Claim 1, characterized in that the signal input (24) for the test signal is at the same time the signal input (24) for switching signals (22) of a switching element (20) for selecting the intermittent-wipe and/or wash functions, and in that the controller (14) recognizes a particular signal, which differs from the switching signals (22) for intermittent wiping or washing, as a test signal at this signal input (24) and, when said test signal occurs, powers the motor (12) for a test mode (Tₜₑₛₜ).

3. Control device according to Claim 2, characterized in that the test signal is formed from a time sequence of switching signals (22).

4. Control device according to Claim 1 or 2, characterized in that the test signal has a negative voltage level.

5. Control device according to one of the preceding claims, characterized in that the duration of the test signal is used to define the duration for which the motor (12) is powered.

6. Control device according to one of the preceding claims, characterized in that, when the test signal has been turned off, the motor (12) remains powered for the rest of the duration of the present wiping cycle (Tw) or for the duration of one wiping cycle (Tw).

7. Control device according to Claim 4, characterized in that it has a debounce filter (32) and a comparator (34) for recognizing the test signal, both of which are preferably integrated in an ASIC (application-specific IC).

## Revendications

1. Dispositif de commande (10) d'un moteur d'essuie-glace (12) pour des véhicules automobiles, en particulier un moteur d'essuie-glace arrière (12), comportant une commande (14) intégrée au moteur (12), avec au moins une entrée de signaux (24),
caractérisé en ce que
la commande (14) reçoit un signal de test par l'intermédiaire de cette entrée de signaux (24) et, lors de son apparition, met sous courant le moteur (12) pour un mode de test (Tₜₑₛₜ).

2. Dispositif de commande selon la revendication 1,
caractérisé en ce que
- l'entrée de signaux (24) pour les signaux de test est en même temps l'entrée de signaux (24) pour des signaux de branchement (22) d'un élément de circuit (20) qui sert à sélectionner les fonctions d'essuyage intermittent et/ou de lavage, et
- la commande (14) identifie, sur cette entrée de signaux (24), un signal déterminé qui s'écarte des signaux de branchement (22) servant à l'essuyage intermittent ou au lavage, en tant que signal de test et, lors de son apparition, met sous courant le moteur (12) pour un mode de test (Tₜₑₛₜ) .

3. Dispositif de commande selon la revendication 2,
caractérisé en ce que
le signal de test est formé à partir d'une suite dans le temps de signaux de branchement (22).

4. Dispositif de commande selon la revendication 1 ou 2,
caractérisé en ce que
le signal de test présente un niveau de tension négatif.

5. Dispositif de commande selon l'une des revendications précédentes,
caractérisé en ce qu'
on détermine la durée de mise sous courant du moteur (12) par la durée du signal de test.

6. Dispositif de commande selon l'une des revendications précédentes,
caractérisé en ce qu'
après le débranchement du signal de test le moteur (12) reste sous courant pour la durée restante du cycle actuel d'essuyage (Tw), ou pour la durée d'un cycle d'essuyage (Tw) .

7. Dispositif de commande selon la revendication 4,
caractérisé en ce qu'
il présente un filtre antibattement (32) et un comparateur (34) servant à identifier le signal de test, qui sont tous les deux de préférence intégrés dans un ASIC (circuit intégré à application spécifique).
